Europäisches Patentamt

European Patent Office

Office européen des brevets

(19)

(11) EP 1 137 074 A2

(12) **EUROPEAN PATENT APPLICATION**

(43) Date of publication:
26.09.2001 Bulletin 2001/39

(51) Int Cl.⁷: **H01L 29/772**

(21) Application number: 01106694.1

(22) Date of filing: 16.03.2001

(84) Designated Contracting States:
**AT BE CH CY DE DK ES FI FR GB GR IE IT LI LU MC NL PT SE TR**
Designated Extension States:
**AL LT LV MK RO SI**

(30) Priority: 17.03.2000 JP 2000077165

(71) Applicant: **Sumitomo Electric Industries, Ltd. Osaka-shi, Osaka 541-0041 (JP)**

(72) Inventors:
• **Nakajima, Shigeru, c/o Yokohama Works Yokohama-shi, Kanagawa 244-8588 (JP)**
• **Otobe, Kenji, c/o Yokohama Works Yokohama-shi, Kanagawa 244-8588 (JP)**
• **Nakata, Ken, c/o Yokohama Works Yokohama-shi, Kanagawa 244-8588 (JP)**

(74) Representative: **Grünecker, Kinkeldey, Stockmair & Schwanhäusser Anwaltssozietät Maximilianstrasse 58 80538 München (DE)**

(54) **Power field effect transistor**

(57) The present invention relates to a power field-effect transistor capable of reducing third-order distortions. The power field-effect transistor 10a comprises a pulse-doped layer 16; a control electrode 18; a cap layer 20; ohmic electrodes 24a, 24b; heavily-doped semiconductor regions 22a, 22b; and a doped semiconductor region 26. The cap layer 20 is made of III-V compound semiconductor provided between the pulse-doped layer 16 and the control electrode 18. The heavily-doped semiconductor region 22a electrically connects the electrode 24a and the pulse-doped layer 16 to each other. The heavily-doped semiconductor region 22b electrically connects the electrode 24b and the pulse-doped layer 16 to each other. The doped semiconductor region 16 is provided in the cap layer 20 so as to electrically connect the heavily-doped semiconductor region 22a and the pulse-doped layer 16 to each other. The doped semiconductor region 26 has a carrier concentration lower than that of the heavily-doped semiconductor region 22a and has a conductive type identical to that of the pulse-doped layer 16.

Fig.1A

EP 1 137 074 A2

**Description**

BACKGROUND OF THE INVENTION

Field of the Invention

The present invention relates to a semiconductor device.

Related Background Art

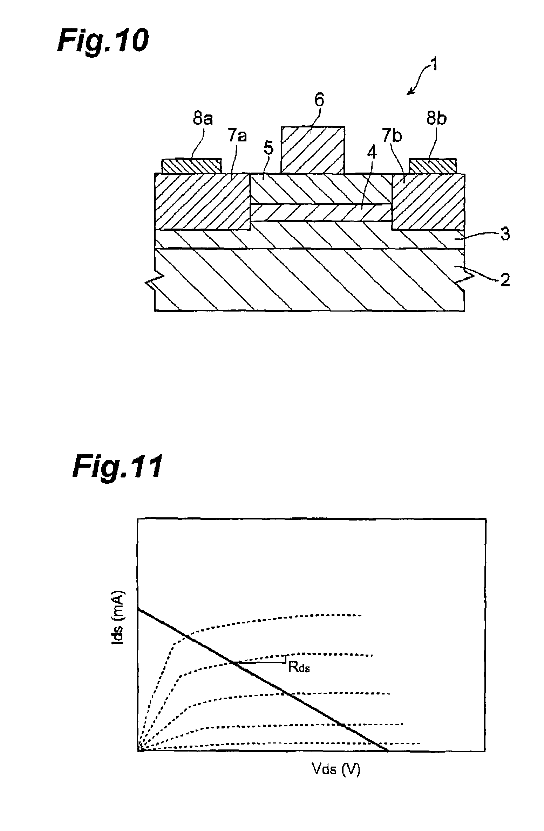

Fig. 10 is a sectional view showing a field effect transistor. This field-effect transistor 1 comprises a buffer layer 3, a pulse-doped layer 4, and a cap layer 5 which are successively stacked on a semiconductor substrate 2. A gate electrode 6 is disposed on the cap layer 5. On both regions adjacent to the sides of the gate electrode 6, a source semiconductor region 7a and a drain Semiconductor region 7b are provided so as to reach the pulse-doped layer 4.

SUMMARY OF THE INVENTION

In recent years digital transmission is utilized to transfer a large amount of data in the field of wireless communications. The inventors have conducted studies in order to apply field-effect transistors to amplifying circuit for large-amplitude and high-output purposes in the digital transmission.

Power field-effect transistors applicable to such a field of application are required to have low-distortion characteristics. For use in base stations of communication systems such as PDC system and CDMA system, the third-order intermodulation distortion (IM3) is particularly important among the low-distortion characteristics because the above-mentioned communication systems requires amplifier circuits to amplify signals including fundamental waves $f_1$, $f_2$ together. The IM3 generates components of frequencies $2f_2$-$f_1$ and $2f_1$-$f_2$ from the signals including fundamental waves $f_1$, $f_2$. Since the frequency of the fundamental wave $f_1$ is close to the frequency of fundamental wave $f_2$, these distortion components are close to the fundamental waves $f_1$, $f_2$. Hence, the distortion components are contained within the amplification band of the amplifying circuit. Consequently, if the IM3 is lowered, high-quality communications with less interference will be possible. Therefore, amplifier circuits suitable for large-amplitude and high-output purposes require transistors capable of reducing the occurrence of third-order intermodulation distortion.

On the other hand, field-effect transistors having a pulse-doped layer provide an excellent linearity of gm in a practical signal input range. Therefore, the field-effect transistors are expected to provide a low-distortion amplifier circuit with a class A amplifying operation.

The inventors conducted various experiments for these field-effect transistors. In one of these experiments, one end of a resistance $R_L$ is connected to the drain of a field-effect transistor, and the other end of resistance $R_L$ is connected to a power supply to form an amplifier circuit. Then, the third-order intermodulation distortion of this amplifier circuit is measured. Fig. 11 shows characteristics of drain current $I_{ds}$ with respect to the drain-source voltage $V_{ds}$ of the field-effect transistor. This graph shows the load line characteristics, exhibited by the resistance $R_L$ connected to the drain, which is downward to the right.

In an amplifier circuit, a load element, such as the resistance $R_L$, is connected to the drain of a power field-effect transistor. In this amplifier circuit having the power field-effect transistor, the intersection between drain current characteristic curves and the load line shifts in response to the amplitude of a relatively large input. Hence, the power field-effect transistor is required to reduce the third-order intermodulation distortion (IM3) on the entire load line.

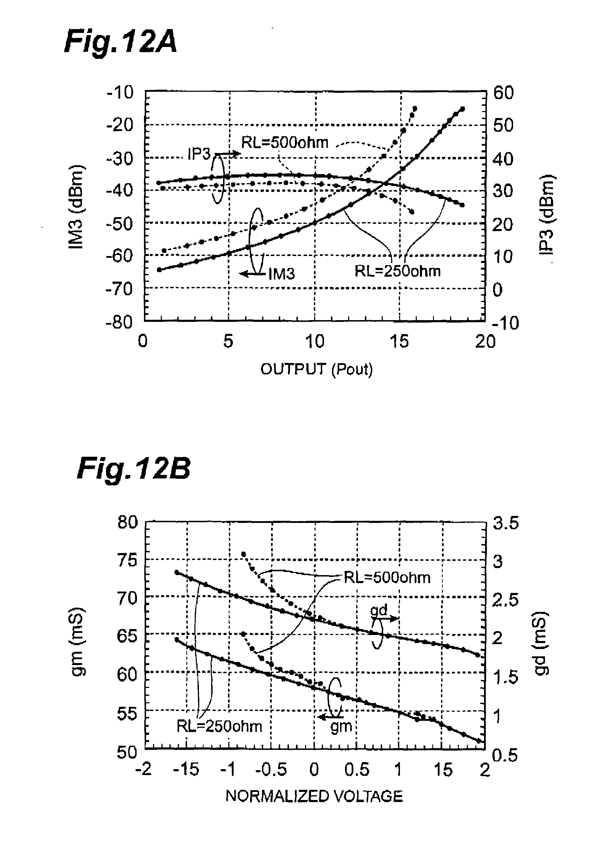

This requirement is also shown by the following measurements. Fig. 12A shows the dependence of third-order intermodulation distortion (IM3) and (IP3) upon the output $P_{out}$, where $R_L$ = 250 ohms and 500 ohms. In the measurements, the frequencies of the fundamental waves $f_1$, $f_2$ are 1900 MHz and 1901 MHz, respectively. $V_{ds}$ = 10 V, and $I_q$ = 40 mA are applied to the transistor. Fig. 12B shows transconductance gm and drain conductance gd with respect to a normalized input amplitude, where $R_L$ = 250 ohms and 500 ohms. The input voltage amplitude is normalized by the maximum voltage amplitude at an output of 13dBm.

Figs. 12A and 12B show measurements indicating that the load element having the smaller $R_L$ provides more favorable performances on the load line. The inventors think the performances arise from the followings the third-order intermodulation distortion (IM3) becomes relatively small on the intersection between the respective drain current curves of field-effect transistor and the load line when the load element has smaller $R_L$. What is desired is that the third-order distortion is further lowered in amplifier circuits using power field-effect transistors.

Therefore, it is an object of the present invention to provide a power field-effect transistor that can reduce the third-order distortion.

The semiconductor device in accordance with the present invention comprises a pulse-doped layer, a control electrode, first and second electrodes, first and second heavily-doped semiconductor regions, and a resistance portion.

The pulse-doped layer is made of a III-V compound semiconductor. The control electrode is provided so as to control current flowing through the pulse-doped layer. The control electrode is also provided between the first and second electrodes. The first heavily-doped semiconductor region electrically connects the first electrode and the pulse-doped layer to each other. The second heavily-doped semiconductor region electrically connects the second electrode and the pulse-doped layer to each other. The resistance region is provided so as to electrically connect the pulse-doped layer and the first electrode to each other.

When the first electrode works as a source electrode, the resistance portion provides a current path from the source electrode to the pulse-doped layer. This current path acts to lower equivalent resistance between the source and drain of the semiconductor device when the semiconductor device operates in its non-saturation region. Consequently, the drain current increases in the non-saturation region operation. In the saturation region operation, the resistance of a depletion region, located just under the control electrode in the pulsed-doped layer, dominates the equivalent resistance between the source and drain. Therefore, the contribution of the current path to the equivalent resistance becomes less significant gradually as the source-drain voltage increases. As the result of the operation in both regions, the drain current change becomes smaller in the saturation region operation. This results in the smaller changes in gd due to the source-drain voltage in the saturation region operation.

When the first electrode works as a drain electrode, the resistance portion provides a current path from the pulse-doped layer to the drain semiconductor region. When the semiconductor device operates in the non-saturation region, the channel resistance in the pulse-doped layer dominates the equivalent resistance between the source and drain of the semiconductor device. In the saturation region operation, while the depletion layer directly under the control electrode makes great contribution to the equivalent resistance between the source and drain of the semiconductor device, the above-mentioned current path acts to reduce this equivalent resistance. This provides the increasing drain current in the saturation region operation. The drain current continues to increase even in higher source-drain voltages. The increase of the drain current causes gd to becomes larger in the higher source-drain voltages. Consequently, the difference in gd in all over the saturation region is reduced.

The semiconductor device in accordance with the present invention may comprise various features that will be described in the following. The invention described in the present application includes any combination of these features.

The semiconductor device in accordance with the present invention may further comprise a cap layer made of a III-V compound semiconductor provided between the pulse-doped layer and the control electrode. The resistance portion may be provided in the cap layer, and may include a doped semiconductor region provided in at least one of a source and a drain. This semiconductor device is realized by a field-effect transistor including the doped semiconductor region.

The doped semiconductor region is provided in the cap layer so as to electrically connect the first heavily-doped semiconductor region and the pulse-doped layer to each other. The doped semiconductor region has a conductive type identical to that of the pulse-doped layer. The doped semiconductor region has a carrier concentration higher than that of the cap layer. The doped semiconductor region may have a carrier concentration lower than that of the first heavily-doped semiconductor region. The doped semiconductor region may also have a carrier concentration higher than that of the pulse-doped layer.

In the semiconductor device, the doped semiconductor region may have a carrier concentration determined such that the doped semiconductor region has its resistance that is at least 10 times a resistance associated with the pulse-doped layer. This provides the semiconductor device provided with its appropriate current/voltage characteristics.

In the semiconductor device, the doped semiconductor region is provided adjacent to the pulse-doped layer and the first heavily-doped semiconductor region. The cap layer has a first region provided with the control electrode, and a second region provided with the doped semiconductor region. The first region may be separated from the second region by a predetermined distance. This configuration prevents the control electrode from being arranged on the doped semiconductor region. The doped semiconductor region is also separated from the control electrode. The separation also prevents capacitive coupling from increasing between the doped semiconductor region and the control electrode.

The semiconductor device in accordance with the present invention may be realized by the following as well. The semiconductor device further comprises a substrate and a third electrode. The third electrode is provided between the first electrode and the control electrode, and is electrically connected to the cap layer. In this semiconductor device, the resistance portion may include a resistor connected between the first and third electrodes and provided on the substrate. This semiconductor device comprises the field-effect transistor and the resistor.

In the semiconductor device, the value of the resistor may be at least 10 times a resistance value associated with the pulse-doped layer. The resistance value in this range provides the semiconductor device with appropriate current/voltage characteristics.

In the semiconductor device, the resistor may be made of at least one of materials such as alloys including Ni and Cr, refractory metal silicides, and tantalum nitride. The resistor may also include a semiconductor resistance region doped with impurity in the substrate. As a consequence, various resistance values can be obtained with an appropriate size.

The semiconductor device may comprise another resistor having a resistance value different from that of the resistor mentioned above. One or more of these resistors may be chosen so as to provide the semiconductor device with appropriate current/voltage characteristics.

BRIEF DESCRIPTION OF THE DRAWINGS

The present invention will now be more readily understood from the following detailed description when read in conjunction with the accompanying drawings, in which:

Figs. 1A and 1B are sectional views showing n-type power field-effect transistors in accordance with embodiments of the present invention;
Fig. 2 is a plan view showing the power field-effect transistor in accordance with an embodiment of the present invention;
Fig. 3 is a schematic view showing a field-effect transistor in accordance with another embodiment;
Fig. 4 is a graph showing drain current characteristics when a power field-effect transistor has a doped semiconductor region or a resistor in the source thereof;
Fig. 5 is a graph showing drain current characteristics when a power field-effect transistor has a doped semiconductor region or a resistor in the drain thereof;
Fig. 6 is an equivalent circuit diagram of the semiconductor device shown in Figs. 1A and 3;
Fig. 7 is a diagram showing an amplifier circuit including the semiconductor device;
Fig. 8 is a graph showing gm and gd characteristics of the power field-effect transistor in accordance with an embodiment of the present invention;
Fig. 9 is a graph showing high-order distortion characteristics of the power field-effect transistor in accordance with an embodiment of the present invention;
Fig. 10 is a sectional view showing a field-effect transistor;
Fig. 11 is a graph showing characteristics of drain current $I_{ds}$ versus drain-source voltage $V_{ds}$ for the field-effect transistor;
Fig. 12A is a graph showing the dependence of third-order intermodulation distortion upon output $P_{out}$; and
Fig. 12B is a graph showing gm and gd versus normalized input amplitude.

DESCRIPTION OF THE PREFERRED EMBODIMENTS

Parts identical to each other will be referred to with reference numerals identical to each other, if possible.

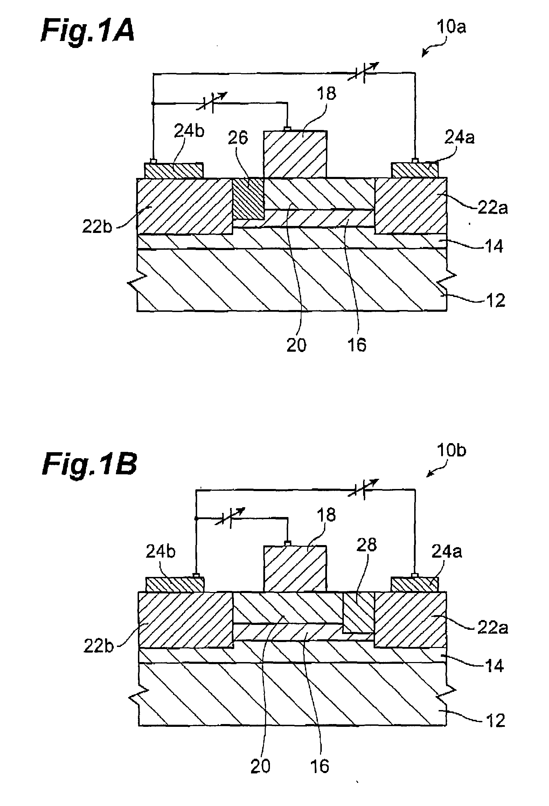

An n-type power field-effect transistor 10a in accordance with an embodiment of the present invention will be described with reference to Fig. 1A. The field-effect transistor 10a, made of a III-V compound semiconductor, is formed on a substrate 12 such as a GaAs semiconductor substrate, and has the following layers provided on this substrate. Formed on the substrate 12 is a buffer layer 14, made of semiconductor such as undoped GaAs semiconductor. Formed on the buffer layer 14 is a pulse-doped layer 16, made of semiconductor such as n-type InGaAs semiconductor and n-type GaAs semiconductor. The pulse-doped layer 16 may be provided so as to form a heavily doped thin layer. On the pulse-doped layer 16, a control electrode 18 is provided so as to control the current flowing through the pulse-doped layer 16. Formed between the pulse-doped layer 16 and the control electrode 18 is a cap layer 20, made of semiconductor such as undoped AlGaAs semiconductor or undoped GaAs semiconductor. Employed for the control electrode 18 is a Schottky metal, such as tungsten, which forms a Schottky junction to the cap layer 20.

Heavily-doped semiconductor regions 22a, 22b are formed for a drain region and a source region, respectively. The heavily-doped semiconductor regions 22a, 22b are provided so as to reach the pulse-doped layer 16 from the surface of cap layer 20. On the heavily-doped semiconductor regions 22a, 22b, ohmic electrodes 24a, 24b are formed, respectively.

The field-effect transistor 10a has a doped semiconductor region 26 such as a lightly doped semiconductor region. One of the source and drain is provided with an LDD semiconductor region. The doped semiconductor region 26 is disposed within the cap layer 20 so as to electrically connect the heavily-doped semiconductor region 22b, which works as a source region, to the pulse-doped layer 16. The doped semiconductor region 26 has a conductive type identical to that of the pulse-doped layer 16. The carrier concentration of the doped semiconductor region 26 is lower than that of the heavily-doped semiconductor region 22b but higher than that of the pulse-doped layer 16. The doped semiconductor region 26 may be arranged adjacent to the heavily-doped semiconductor region 22b and the pulse-doped layer 16. The doped semiconductor region 26 may extend along the heavily-doped semiconductor region 22b so as to reach the pulse-doped layer 16 from the surface of cap layer 20. The doped semiconductor region 26 is formed within the cap layer 20 and arranged in a region different from that between the control electrode 18 and the pulse-doped layer 16. This arrangement allows the control electrode to control the channel current flowing through the pulse-doped layer 16 even when the doped semiconductor region 26 is provided with the cap layer 20.

With reference to Fig. 1B, an n-type power field-effect transistor 10b in accordance with an embodiment of the present invention will now be described. The field-effect transistor 10b has a doped semiconductor region 28 instead of the doped semiconductor region 26. The doped semiconductor region 28 is arranged within the cap layer 20 so as to electrically connect the heavily-doped semiconductor region 22a, which works as a drain region, to the pulse-doped layer 16. The doped semiconductor region 28 has the configuration and features similar to those of the doped semiconductor region 26 except that the doped semiconductor region 28 is provided in conjunction with the drain.

Typical thickness and carrier concentration of each layer are as follows:

| Layer name | Thickness | Carrier concentration |
|---|---|---|
| Buffer layer pulse-doped layer | About 1000 nm at least 5 nm but not exceeding 30 nm | $5 \times 10^{15}/cm^3$ or less at least $1 \times 10^{17}/cm^3$ but not exceeding $3 \times 10^{18}/cm^3$ |
| cap layer | at least 10 nm but not exceeding 100 nm | $1 \times 10^{16}/cm^3$ or less |
| doped semiconductor region | | $1 \times 10^{17}/cm^3$ to $1 \times 10^{18}/cm^3$ |

The doped semiconductor region in the cap layer is provided with the carrier concentration above, which is greater than that of the cap layer.

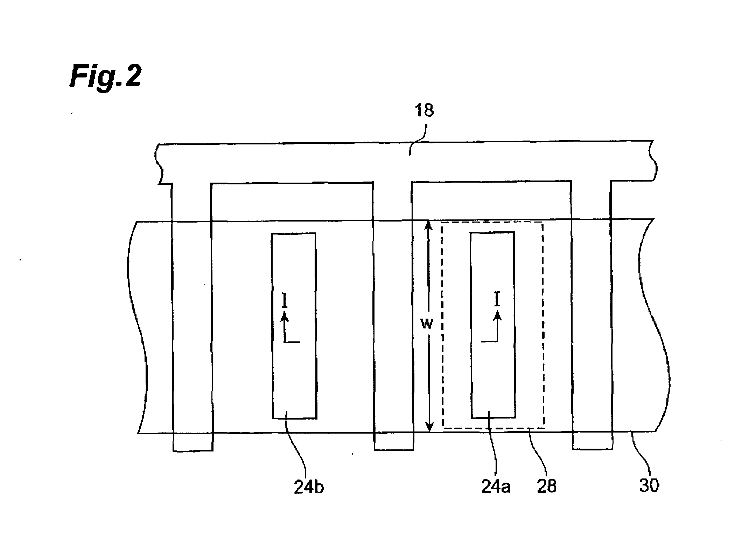

Fig. 2 shows the n-type power field-effect transistor 10b in accordance with an embodiment of the present invention. Fig. 1B corresponds to the cross sectional view taken along the line I-I in Fig. 2. Although the following description will exemplify the field-effect transistor 10b/ this description is similarly applied to the field-effect transistor 10a.

The control electrode 18 extends so as to partition a transistor region 30 into the source and drain regions. The doped semiconductor region 28 is arranged along the control electrode 18, and can be arranged over the whole transistor width W. The doped semiconductor region 28 is arranged such that control electrode 18 is not provided thereon. The doped semiconductor region 28 is placed apart from the control electrode 18 by a predetermined spacing.

The field-effect transistor as mentioned above is obtained by the following manufacturing process, for example. The buffer layer 14, pulse-doped layer 16, and cap layer 20 are epitaxially grown in succession on the substrate 12 in OMVPE method, for example. Subsequently, impurities are introduced in ion implantation method in order to form the drain and source regions 24a, 24b. For the ion implantation condition, the ion species is Silicon, the acceleration voltage is 90 kev, and the dose is 2 to $4 \times 10^{13}$ cm$^{-2}$, for example.

Successively, in order to form a doped semiconductor region, impurity atoms are introduced in ion implantation method. For the ion implantation condition, the ion species is Silicon, the acceleration voltage is 70 keV, and the dose is $4 \times 10^{12}$ cm$^{-2}$, for example. Thereafter, the implanted semiconductor lamination is annealed to eliminate the crystalline lattice defect generated by the ion implantation, aswell as to electrically activate the implanted impurities. For the annealing, RTP method is employed at a temperature of 870°C for 5 seconds, for example. subsequently, ohmic electrodes are formed on the drain and source regions 24a, 24b. Thereafter, the Schottky electrode 18 is formed on the cap layer 20. After these manufacturing process, the drain and source regions 24a, 24b yield a sheet resistance of about 300 to 400 ohms/square. Acombined sheet resistance of semiconductor layers including the buffer layer, the pulse-doped layer, the doped semiconductor region and the cap layer is about 800 to 1200 ohms/square.

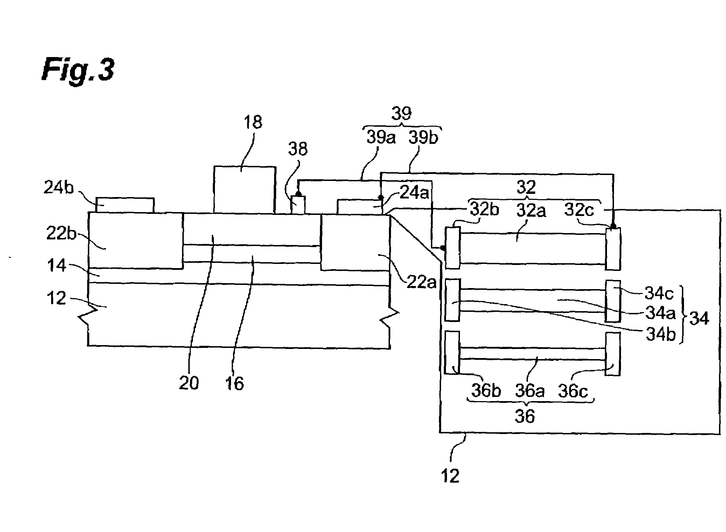

Fig. 3 shows a power semiconductor device. The power semiconductor device includes a field-effect transistor 10c and a resistor. The field-effect transistor 10c comprises a buffer layer 14, a pulse-doped layer 16, a control electrode 18, and a cap layer 20 which are arranged on a substrate 12. Heavily-doped semiconductor regions 22a, 22b are provided for a drain and a source, respectively. The heavily-doped semiconductor regions 22a, 22b are arranged so as to reach the pulse-doped layer 16 from the surface of cap layer 20. On the heavily-doped semiconductor regions 22a, 22b, ohmic electrodes 24a, 24b are provided.

As shown in Fig. 3, the control electrode 18 extends so as to partition a transistor region 30 into the source and drain regions. Each of the heavily-doped semiconductor regions 22a, 22b extend along the control electrode 18. The heavily-doped semiconductor regions 22a, 22b can be arranged over the whole transistor width W, respectively. The heavily-doped semiconductor regions 22a, 22b is arranged such that the control electrode 18 is not provided thereon. A separating regions are provided so as to separate the control electrode 18 from the heavily-doped semiconductor regions 22a, 22b by a predetermined spacing.

The separating regions are provided with a tap electrode 38, The tap electrode 38 can be arranged along the control electrode 18. One or more the separating regions may be provided with one or more tap electrodes arranged along the control electrode 18, respectively. The tap electrode 38 may be arranged in one of the source and drain regions. The tap electrode 38 is formed so as to be able to come into ohmic contact with the cap layer 20.

One or more resistors may be provided on the substrate 12. In Fig. 3, this embodiment shows three resistors 32, 34, 36 having respective resistance values different from each other. The resistor 32 has a resistive layer 32a and a pair of electrodes 32b, 32c arranged at both ends of the resistance layer 32a. Although the distance between the pair of electrodes is substantially the same among the resistors 32, 34, 36, their resistive layers have respective widths different from each other. In the embodiment shown in Fig. 3, the electrode 32b of resistor 32 is connected to the electrode 24a by way of a lead wire 39a, whereas the electrode 32c of resistor 32 is connected to the electrode 24b by way of a lead wire 39b. Both of the lead wires 39a, 39b and the electrodes 32a, 32b are provided on the substrate 12. Although the resistor 32 is connected to the power field-effect transistor in the embodiment shown in Fig. 3, one or more among the resistors 32, 34, 36 can be utilized.

The resistors 32, 34, 36 may be made of at least one of, for example, alloys such as NiCr, silicides such as $WSi_x$, and tantalum nitride. These materials have a relatively high specific resistance and a low temperature coefficient. The first resistor may also employ an impurity-doped semiconductor resistance region formed in the substrate. The semiconductor resistance region can be formed in ion implantation method. For the ion implantation condition, the ion species is Silicon, the acceleration voltage is 80 kev, and the dose is $1.0 \times 10^{13}$ cm$^{-2}$, for example. As a consequence, the various values of the first resistor can be obtained with the appropriate size thereof.

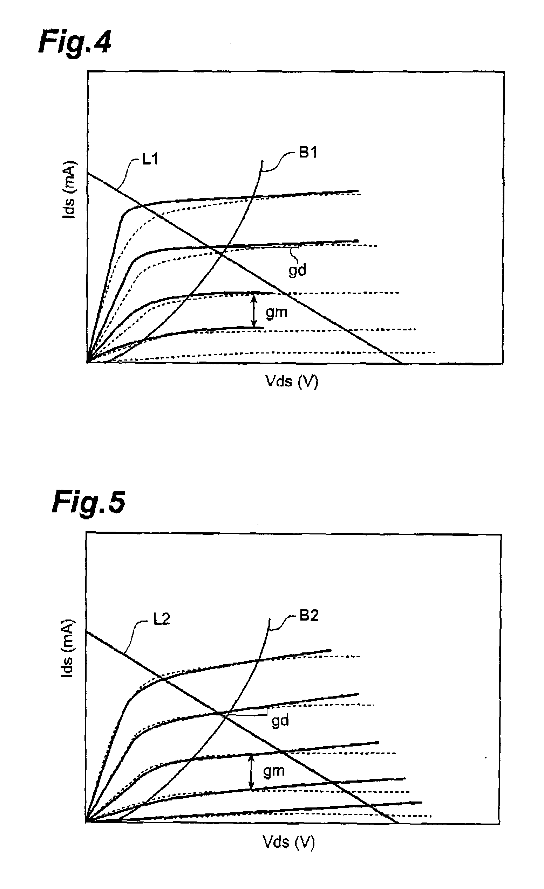

Fig. 4 shows drain current characteristics of the power field-effect transistor having a source provided with a doped semiconductor region or resistor. Fig. 5 is a graph showing drain current characteristics of the power field-effect transistor having its drain provided with a doped semiconductor region or a resistance. In Figs. 4 and 5, solid lines B1 and B2 indicate the boundary between saturation and non-saturation regions, respectively. Also, in these graphs, solid curves indicate drain current characteristics of the transistors in accordance with embodiments, whereas broken lines indicate characteristics of a transistor for purposes of comparison.

Figs. 4 and 5 each shows some drain current curves for a number of voltage values applied to the control electrode. The drain current curves are changed according to the voltage fed to the control electrode. A virtual load line is also shown in each graph. The virtual load line is set so as to intersect a number of drain current curves in the saturation region. The virtual load is an approximate line determined so as to simulate a real load line in an amplifying circuit having the present field-effect transistor. At each intersection, gm and gd can be determined. The drain current curves extend from the origin through a non-saturation region and then a first saturation region to a second saturation region, which are arranged in increasing order of source-drain voltage.

When a doped semiconductor region or a resistor is arranged in the source of the field-effect transistor, its drain current characteristic exhibits as follows. The doped semiconductor region or resistor, provided in the source, is coupled to the channel of pulse-doped layer in parallel with the heavily-doped source semiconductor region. This bypass resistance can increase the current in the non-saturation region operation to decrease gd in the first saturation region operation, as compared with that in the conventional field-effect transistors. Thus added doped semiconductor region or resistor has a resistance lower than that of the source semiconductor region.

When a doped semiconductor region or a resistor is arranged in the drain of the field-effect transistor, its drain current curves exhibits as follows. The doped semiconductor region or resistor, provided in the drain, is coupled to the channel of pulse-doped layer in parallel with the heavily-doped drain semiconductor region. The addition of this bypass resistance allows the drain conductance gd to increase in the second saturation region, as compared with that in the conventional field-effect transistors. Thus added doped semiconductor region or resistor has a resistance lower than that of the drain semiconductor region.

Letting $gd_{max}$ and $gd_{min}$ be the maximum and minimum values of gd at the intersections, respectively, the absolute value of their difference satisfies $|gd_{max}-gd_{min}|/gd_{max} \leq 0.5$ in the present field-effect transistor.

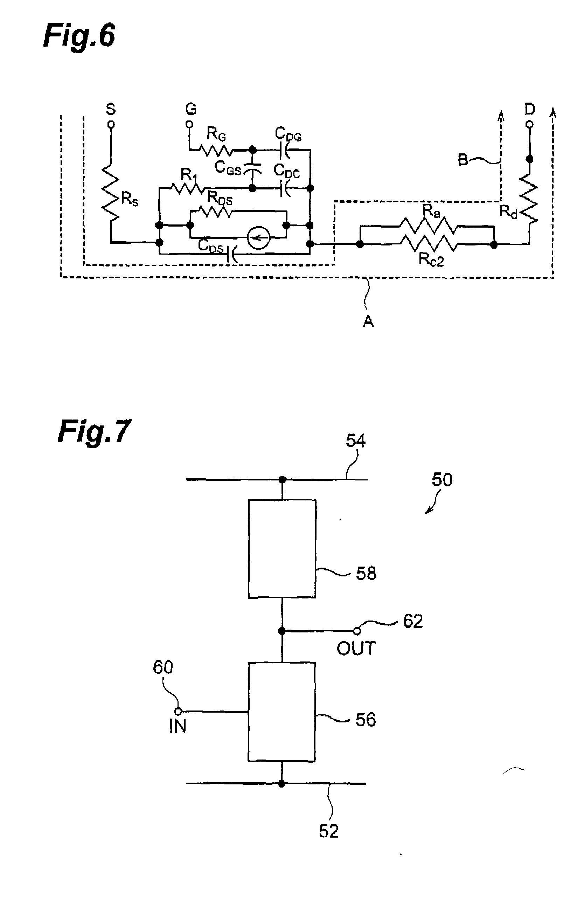

Fig. 6 is an equivalent circuit diagram for the semiconductor devices shown in Figs. 1A and 3. In Fig. 6, $R_s$ indicates the resistance of the heavily-doped semiconductor region 22b for the source, $R_d$ indicates the resistance of the heavily-doped semiconductor region 22a for the drain, $R_{C1}$ indicates the channel resistance of the pulse-doped layer 16 controlled by the control electrode, $R_a$ indicates the resistance of the doped semiconductor region 28, and $R_{C2}$ indicates the resistance of the part of the pulse-doped layer 16 adjacent the doped semiconductor region 28. The resistance $R_{C2}$ changes in response to a voltage supplied to the control electrode G.

Referring to Fig. 6, two current paths are provided between the source S and the drain D, i.e., a first current path A traveling by way of the resistances $R_s$, $R_{C1}$, $R_{C2}$, and $R_d$, and a second current path B traveling by way of the resistances $R_g$, $R_{C1}$, $R_a$ and $R_d$. The respective semiconductor devices shown in Figs. 1A and 3 provide additional current paths as described above. The inventors estimated the resistance $R_{C2}$, which is a combined sheet resistance of semiconductor layers including the buffer layer, the pulse-doped layer and the cap layer, to be 1200 ohms/square. This value is associated with a sheet resistance of the pulse-doped layer. If the resistance $R_a$, associated with a sheet resistance of the doped semiconductor region, is 12000 ohms/square or higher, then the combination of the resistances $R_{C2}$ and $R_a$ in parallel yield a composite resistance of at least 1091 ohms/square but less than 1200 ohms/square. This shows that the resistance $\underline{R}_a$, arranged in parallel with the resistance $R_{C2}$, can increases the drain current.

The power field-effect transistor or power device in accordance with this embodiment is applicable to an amplifier circuit amplifying signals including at least two frequencies $f_1$, $f_2$. this amplifier circuit receives input signals including the frequencies $f_1$, $f_2$ at the control electrode of the transistor and can amplify the signals within a predetermined frequency range including the frequencies $f_1$, $f_2$. The frequencies $f_1$, $f_2$ have such a relationship that at least one of $2 \times f_1 - f_2$ and $2 \times f_2 - f_1$ is included in the predetermined frequency range associated with the amplification. In such a case, the amplification band will include high-order distortions therein after the amplification. This amplifier circuit includes a field-effect transistor having a control electrode connected to the input, a source connected to a reference potential line, and a drain connected to the other reference potential through a load, and the output can be taken out from the drain.

Fig. 7 shows an amplifier circuit using the semiconductor device. This amplifier circuit 50 comprises a semiconductor device 56 and a load device 58 which are connected in series between a first power supply line 52 and a second power supply line 54. The control electrode of semiconductor device 56 is electrically connected to an input (IN) 60. The node between the semiconductor device 56 and the load device 58 is electrically connected to an output (OUT) 62. The field-effect transistor and power device described above can be used as the semiconductor device 56. The load device 58 includes a resistive impedance realizing the virtual load line above.

The inventors conducted experiments for estimating characteristics obtained when the semiconductor device in accordance with the embodiment of the present invention is applied to the above-mentioned amplifier circuit. Subsequently, the results will be described.

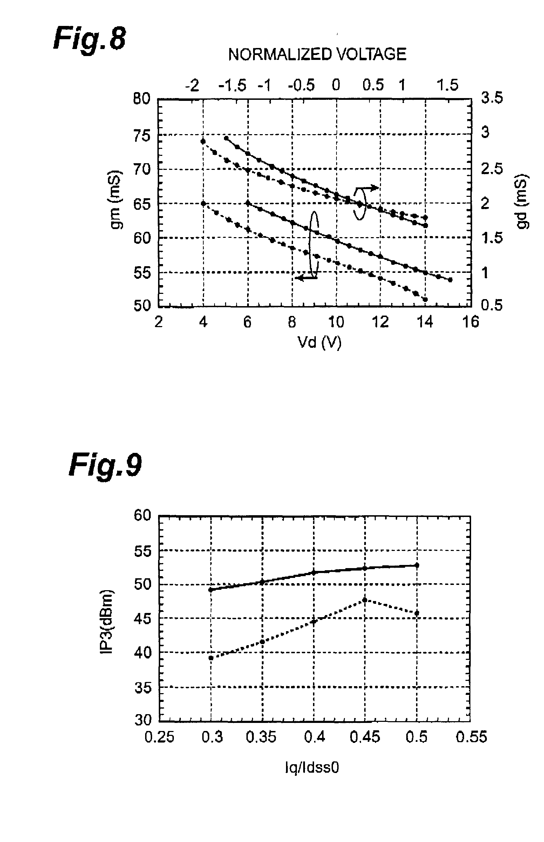

Fig. 8 is a graph showing gm and gd characteristics of the power field-effect transistor in accordance with the present embodiment. The abscissa of the graph indicates the value of $V_d$ and the normalized value of $V_d$. The voltage amplitude $V_d$ is normalized by the maximum voltage amplitude at an output of 13dBm.

The third-order intermodulation distortion (IM3) is expressed by use of the second derivative of the transconductance gm, drain conductance gd, and gate capacitance $C_{gs}$ with respect to gate bias $V_{gs}$ and drain bias $V_{ds}$.

The transconductance gm and drain conductance gd are approximated by:

$$gm = a_1 + b_1 \times V_{ds} + c_1 \times V_{ds}^2 + d_1 \times V_{ds}^3 + \cdots$$

$$gd = a_2 + b_2 \times V_{ds} + c_2 \times V_{ds}^2 + d_2 \times V_{ds}^3 + \cdots$$

In the field-effect transistor, gm and gd have a favorable linearity with respect to $V_{ds}$. That means that the field-effect transistor, as shown in Fig. 8, can achieve the following relationships:

$$|b_1/c_1| \geq 10$$

$$|b_2/c_2| \geq 5$$

In the field-effect transistor as shown in Fig. 10, for purposes of comparison, values corresponding to the above ratios are 2.9 and 0.2, respectively. It is seen that gm and gd of the field-effect transistor in the embodiment are superior to those of the conventional field-effect transistor.

The third-order distortion becomes more favorable when the term of second-order differential coefficient of gm with respect to $|V_{ds}|$ is smaller. Therefore, smaller $|c_1|$ is better. In Fig. 8, the second-order differential coefficient of gm with respect to $V_{ds}$ is 0.3, whereas the second-order differential coefficient of gd with respect to $V_{ds}$ is 0.04. In the conventional structure, by contrast, the second-order differential coefficient of gm with respect to $V_{ds}$ is 1.1, whereas the second-order differential coefficient of gd with respect to $V_{ds}$ is 0.13.

As described above, the third-order intermodulation distortion relates to the second derivative of transconductance gm and drain conductance gd with respect to drain bias $V_{ds}$. The third-order intermodulation distortion also depends on the second-order differential coefficient of gm with respect to $V_{ds}$, and the third-order differential coefficient of gd with respect to $V_{ds}$. In the field-effect transistor in accordance with the embodiment, the third-order differential coefficient of gm with respect to $V_{ds}$ is 0.43, whereas the third-order differential coefficient of gd with respect to $V_{ds}$ is 0.028. In the conventional structure, by contrast with the above values, the third-order differential coefficient of gm with respect to $V_{ds}$ is 0.64, whereas the third-order differential coefficient of gd with respect to $V_{ds}$ is 0.13. It is understood that high-order distortion characteristics (IP3) of the field-effect transistor in accordance with the embodiment are also superior to those of the conventional field-effect transistor.

Fig. 9 shows high-order distortion characteristics (IP3) of the power field-effect transistor in accordance with an embodiment of the present invention. In Fig. 9, the abscissa indicates the current ratio $I_q/I_{dss0}$ (where $I_q$ is the idle current, and $I_{dss0}$ is the drain current when $V_g$ = 0 V), whereas the ordinate indicates the high-order distortion characteristic in dBm. In the measurement, a voltage of 10 V was applied to the drain, input signals including frequency components $f_1$ = 1900 MHz and $f_2$ = 1901 MHz were applied to the gate, and an output power of $P_{out}$ = 20 dBm (S.C. L) was obtained. Fig. 9 shows that the high-order distortion characteristics of the present device are superior to conventional ones within the measurement range. The above characteristics reflect the dependence of gm and gd upon $V_{ds}$, as shown in Fig. 6 superior to that in the conventional field-effect transistor.

While the present invention is described with reference to the drawings in the foregoing, the present invention is not restricted by the above-mentioned embodiments. For example, a power field-effect transistor may comprise an n-type pulse-doped layer, a control electrode, a cap layer, first and second electrodes provided in regions adjacent to both sides of the control electrode, a first heavily-doped semiconductor region provided so as to electrically connect the first electrode to the pulse-doped layer, and a second heavily-doped semiconductor region provided so as to electrically connect the second electrode to the pulse-doped layer, whereas the part of the first and second heavily-doped n-type semiconductor regions may be doped with impurity, such as hydrogen (H), oxygen (o), and/or boron (B).

## Claims

1. A semiconductor device comprising:

   a pulse-doped layer made of a III-v compound semiconductor;
   a control electrode provided so as to control current flowing through said pulse-doped layer;
   first and second electrodes, said control electrode being provided between the first and second electrodes;
   a first heavily-doped semiconductor region provided so as to electrically connect said first electrode and said pulse-doped layer to each other;
   a second heavily-doped semiconductor region provided so as to electrically connect said second electrode and said pulse-doped layer to each other; and
   a resistance portion provided so as to provide a current path from said pulse-doped layer to said first electrode.

2. A semiconductor device according to claim 1, further comprising a cap layer, made of a III-V compound semiconductor, provided between said pulse-doped layer and said control electrode;

   wherein said resistance portion includes a doped semiconductor region provided in said cap layer for at least one of a source and a drain of the semiconductor device
   wherein said doped semiconductor region has a carrier concentration higher than that of said cap layer.

3. A semiconductor device according to claim 2, wherein said doped semiconductor region is provided so as to electrically connect said first heavily-doped semiconductor region and said pulse-doped layer to each other; and
   wherein said doped semiconductor region has a carrier concentration lower than that of said first heavily-doped semiconductor region and has a conductive type identical to that of said pulse-doped layer.

4. A semiconductor device according to claim 2, wherein said doped semiconductor region is provided so as to electrically connect said first heavily-doped semiconductor region and said pulse-doped layer to each other; and
   wherein said doped semiconductor region has a carrier concentration higher than that of said pulse-doped layer and has a conduction type identical to that of said pulse-doped layer.

5. A semiconductor device according to claim 2, wherein said doped semiconductor region is provided adjacent to said pulse-doped layer and said first heavily-doped semiconductor region;

   wherein said cap layer has a first region provided with said control electrode and a second region provided with said doped semiconductor region; and
   wherein said first region is separated from said second region by a predetermined distance.

6. A semiconductor device according to claim 2, wherein said doped semiconductor region is provided so as to electrically connect said first heavily-doped semiconductor region and said pulse-doped layer to each other; and
   wherein said doped semiconductor region has a carrier concentration determined so as to have its resistance, said resistance being at least 10 times a resistance associated with said pulse-doped layer.

7. A semiconductor device according to claim 1, further comprising:

a substrate; and
a third electrode provided between said first electrode and said control electrode so as to be electrically connected to said cap layer;
wherein said resistance portion includes a resistor provided on said substrate so as to electrically connect said first electrode to said third electrode.

8. A semiconductor device according to claim 7, wherein said resistor is made of at least one of alloy including Ni and Cr, refractory metal silicide, and tantalum nitride.

9. A semiconductor device according to claim 7, wherein said resistor includes an impurity-doped semiconductor region provided on said substrate.

10. A semiconductor device according to claim 7, further comprising another resistor having a resistance value different from that of said resistor.

*Fig.1A*

*Fig.1B*

# Fig.2

EP 1 137 074 A2

# Fig.3

EP 1 137 074 A2

***Fig.4***

***Fig.5***

# Fig.6

# Fig.7

# Fig.8

NORMALIZED VOLTAGE

# Fig.9

## Fig.10

## Fig.11

## Fig.12A

## Fig.12B